# EUROPEAN PATENT APPLICATION

(11) **EP 4 357 712 A1**
(43) Date of publication of application: **24.04.2024**
(21) Application number: 23204131.9
(22) Date of filing: 17.10.2023
(51) Int. Cl.: F27B 3/08, F27D 21/04, F27D 19/00, F27D 11/10, H05B 7/144

(54) **ELECTRODE VIBRATION DETECTION MODULE AND METHODS THEREOF**

(30) Priority: 18.10.2022 US 202263417155 P
(71) Applicant: AMI INTERNATIONAL SAPI de C.V., 64650 Monterrey, Nuevo León (MX)
(72) Inventor: Sanchez, Eric Garza, 64619 Monterrey, Nuevo León (MX); Diaz, Guillermo Fernandez, 64859 Monterrey, Nuevo León (MX)
(74) Representative: Schröer, Gernot H.

(57) **Abstract**

Electrode vibration detection modules (EVDM) and methods of detecting vibration of an electrode of an electric arc furnace (EAF) using an EVDM are provided, in which the EVDM receives and/or ascertains waveform signals corresponding to voltage values and current values associated with an electrode voltage mea sured between the electrode and the bottom of the EAF shell (electrode voltage) and the electrical current passing through the electrode and is configured to identify conditions for electrode vibration based, at least in part, on the waveform signals and to trigger an alarm and/or modify the operation of the EAF by adjusting the location of the electrode in the EAF.

## Description

### TECHNICAL FIELD

Embodiments of the presently-disclosed invention relate generally to electrode vibration detection modules (EVDM) and methods of detecting vibration of an electrode of an electric arc furnace (EAF) using an EVDM, in which the EVDM receives and/or ascertains waveform signals corresponding to voltage values and current values associated with an electrode voltage measured between the electrode and the bottom of the EAF shell (electrode voltage) and the electrical current passing through the electrode and is configured to identify conditions for electrode vibration based, at least in part, on the waveform signals and to trigger an alarm and/or modify the operation of the EAF by adjusting the location of the electrode in the EAF.

### BACKGROUND

The traditional method of steel production is based on a blast furnace (BOF) route in which iron ore is reduced and molten in a blast furnace using coke before refining in BOF converter. The coke burns and produces energy and the iron ore is reduced due to its reactions with carbon and carbon monoxide. However, in the last few years the Electric Arc Furnace (EAF) steel making process is rapidly gaining interest over the BOF technology worldwide.

Among the advantages of the EAF process, next to lower emissions, flexibility is an argument on behalf of EAFs. This process is extremely flexible compared with the BOF route, which cannot be turned on and off at will in accordance with current market situation. The tendency towards more advanced, flexible, and cleaner processes calls for technology which can be quickly implemented and adapted to the specific needs of each steel producer.

An EAF used for steelmaking generally includes a refractory-lined vessel covered with a retractable roof, through which one or more electrodes enter the furnace. In this regard the EAF may generally be considered to have a shell, which consists of the sidewalls and lower steel "bowl", a hearth, which consists of the refractory that lines the lower bowl, and the roof, which may be refractory-lined or water-cooled and can be shaped as a section of a sphere, or as a frustum (conical section). The roof also supports the refractory delta in its center, through which one or more electrodes enter.

A typical alternating current EAF may be powered by a three-phase electrical supply and therefore has three electrodes. The electrodes may be round in section, and typically in segments with threaded couplings, so that as the electrodes wear, new segments can be added. In this regard, an arc forms between the charged material (e.g., scrap steel to be melted) and the electrode. The charge (e.g., scrap steel) may be heated both by current passing through the charge and by the radiant energy evolved by the arc. The electric arc temperature reaches around 3,000 °C (5,400 °F), thus causing the lower sections of the electrodes to glow incandescently when in operation.

The EAF is typically built on a tilting platform so that the resulting liquid steel can be poured into another vessel for transport. The operation of tilting the furnace to pour molten steel is called "tapping". Originally, all steelmaking furnaces had a tapping spout closed with refractory that washed out when the furnace was tilted, but often modern furnaces have an eccentric bottom tap-hole (EBT) to reduce inclusion of nitrogen and slag in the liquid steel. These furnaces have a taphole that passes vertically through the hearth and shell, and is set off-centre in the narrow "nose" of the egg-shaped hearth. It is filled with refractory sand, such as olivine, when it is closed off.

There, however, remains a need in the EAF art for a method and/or module that may monitor and/or detect vibration of an electrode (or electrodes) of an EAF via waveform signals corresponding to voltage values and current values associated with an electrode voltage measured between the electrode and the bottom of the EAF shell (electrode voltage) and the electrical current passing through the electrode(s).

### SUMMARY OF INVENTION

Certain embodiments according to the invention provide an electrode vibration detection module (EVDM) in operative communication with an electrode electrical sensors and actuators (e.g., one or more electrodes) of an electric arc furnace (EAF), in which the EVDM receives and/or ascertains waveform signals corresponding to voltage values and current values associated with an electrode voltage measured between the electrode and the bottom of the EAF shell (electrode voltage) and the electrical current passing through the electrode (electrode current) and is configured to identify conditions for electrode vibration based, at least in part, on the waveform signals and to trigger an alarm and/or modify the operation of the EAF by adjusting the location of the electrode in the EAF. In accordance with certain embodiments of the invention, for example, the EVDM comprises a computer processor configured to receive waveform signals corresponding to voltage values and current values associated with an electrode voltage measured between the electrode and the bottom of the EAF shell (electrode voltage) and the electrical current passing through the electrode, calculating with these signals the root mean square (RMS) values for electrode current and electrode voltage (RMS current, RMS voltage) at a sampling frequency corresponding to half alternating current (AC) cycle of the electrical power source (RMS sampling frequency) and define an EVDM queue having an EVDM queue length based upon an EVDM window time and the RMS sampling frequency. In accordance with certain embodiments of the invention, the EVDM window time may be a predefined time period or a user selected time period over which individual samples of the RMS current and voltage values (RMS values) are received and/or ascertained. The EVDM may also include one or more sub-modules (e.g., alarm modes) that are selectable by a user, the one or more sub-modules being configured to trigger an internal alarm occurrence (IAO) associated with electrode vibration detection based on a comparison performed in the computer processor of (i) the individual samples of the RMS values and (ii) one or more predefined electrical profiles associated with electrode vibration detection. In accordance with certain embodiments of the invention, the one or more sub-modules may be configured to produce vibration data for each individual sample defined as being either a respective IAO or a respective non-internal alarm occurrence (NIAO). The computer processor may further be configured to accumulate the vibration data for each individual sample from the one or more sub-modules until the EVDM queue length is full, and trigger an external vibration alarm (EVA) if a minimum percentage of the vibration data is defined as being comprised of respective IAOs.

In another aspect, the present invention provides methods of detecting vibration of an electrode (e.g., one or more electrodes) of an EAF, in which the method may comprise the following steps: (a) providing an EVDM, such as those described and disclosed herein, in operative communication with the electrode electrical sensors and actuators; (b) receiving waveform signals corresponding to voltage values and current values associated with an electrode voltage measured between the electrode and the bottom of the EAF shell (electrode voltage) and the electrical current passing through the electrode in the computer processor of the EVDM; (c) calculating the electrode RMS voltage and electrode RMS current at the RMS sampling frequency; (d) selecting one or more sub-modules (e.g., alarm modes), in which the one or more sub-modules may be configured to trigger an internal alarm occurrence (IAO) associated with electrode vibration detection based on a comparison performed in the computer processor of (i) the individual samples of the RMS values and (ii) one or more predefined electrical profiles associated with electrode vibration detection. In accordance with certain embodiments of the invention, in which the one or more sub-modules may be configured to produce vibration data for each individual sample defined as being either a respective IAO or a respective non-internal alarm occurrence (NIAO); and (e) accumulating the vibration data for each individual sample from the one or more selected sub-modules until the EVDM queue length is full, and trigger an external vibration alarm (EVA) if a minimum percentage of the vibration data is defined as being comprised of respective IAOs.

In another aspect, the present invention provides a method of operating an EAF including a furnace body defining an interior portion including a refractory-lined hearth and one or more electrodes extending into the interior portion, in which the method comprises detecting vibration of the one or more electrodes, such as via a method described and disclosed herein, and adjusting a location of the one or more electrodes relative to the refractory-lined hearth by raising the one or more electrodes away from the refractory-lined hearth.

In yet another aspect, the present invention provides an EAF system comprising (i) an EAF including a furnace body defining an interior portion including a refractory-lined hearth and one or more electrodes extending into the interior portion; and (ii) an electrode vibration detection module (EVDM) such as those described and disclosed herein. In accordance with certain embodiments of the invention, the EVDM may be in operative communication with the one or more electrode electrical sensors and actuators.

### BRIEF DESCRIPTION OF THE DRAWING(S)

The invention now will be described more fully hereinafter with reference to the accompanying drawings, in which some, but not all embodiments of the invention are shown. Indeed, this invention may be embodied in many different forms and should not be construed as limited to the embodiments set forth herein; rather, these embodiments are provided so that this disclosure will satisfy applicable legal requirements. Like numbers refer to like elements throughout, and wherein:
Figure 1 illustrates an example user interface 1 for the selection of the one or more sub-modules (e.g., internal alarm(s));
Figure 2 illustrates a flow diagram for the operation of an EVDM in accordance with certain embodiments of the invention;
Figure 3 illustrates a flow diagram for the operation of a first sub-module (e.g., internal alarm mode) of an EVDM in accordance with certain embodiments of the invention;
Figure 4 illustrates a flow diagram for the operation of a second sub-module (e.g., internal alarm mode) of an EVDM in accordance with certain embodiments of the invention; and
Figure 5A illustrates a state diagram for the concept related to an oscillation mode (e.g., third-sub-module) in which every entry into the regulating state or state stagnation, the third sub-module decrements the variable by a constant factor determined by the variable "downslope", on the contrary, if there is a state change (or oscillation) between open circuit and short circuit, the third sub-module increments the variable using upProportion times the distance from the variable to 1.0, thus approaching 1.0 in a negative exponential decay behavior;
Figure 5B illustrates that the growth of the variable using upProportion = 0.001, approaches 1.0 in a negative exponential decay behavior in that it has a rapid growth that gradually slows down converging to 1.0;
Figure 5C illustrates that if the system goes into regulating state or if it remains in the current state, then the variable has a constant downward slope;
Figure 5D illustrates a flow diagram for the operation of a third sub-module (e.g., internal alarm mode) of an EVDM in accordance with certain embodiments of the invention; and

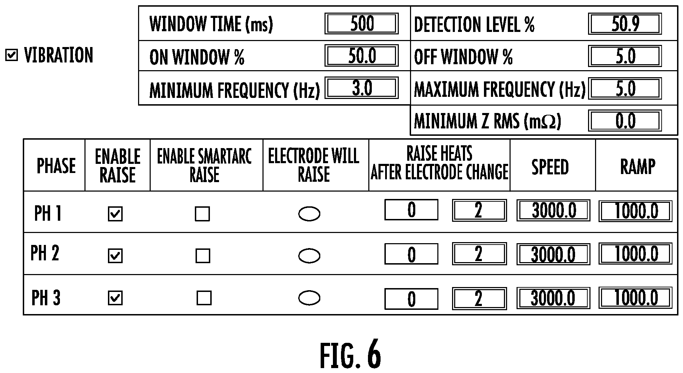

Figure 6 illustrates an example user interface for the electrode profile configuration.

### DETAILED DESCRIPTION

Embodiments of the invention now will be described more fully hereinafter with reference to the accompanying drawings, in which some, but not all embodiments of the invention are shown. Indeed, the present invention may be embodied in many different forms and should not be construed as limited to the embodiments set forth herein; rather, these embodiments are provided so that this disclosure will satisfy applicable legal requirements. As used in the specification, and in the appended claims, the singular forms "a", "an", "the", include plural referents unless the context clearly dictates otherwise. As used herein, the term "and/or" includes any and all combinations of one or more of the associated listed items.

Embodiments of the present invention relate generally to electrode vibration detection modules (EVDM) and methods of detecting vibration of an electrode of an electric arc furnace (EAF) using an EVDM are provided, in which the EVDM receives and/or ascertains waveform signals corresponding to voltage values and current values associated with an electrode voltage measured between the electrode and the bottom of the EAF shell (electrode voltage) and the electrical current passing through the electrode and is configured to identify conditions for electrode vibration based, at least in part, on the waveform signals and to trigger an alarm and/or modify the operation of the EAF by adjusting the location of the electrode in the EAF. In this regard, certain embodiments of the invention can detect an onset of electrode vibration, trigger an alarm, and/or automatically adjust the position of the electrode(s) prior to the degree of electrode vibration becoming so great that portion(s) of the electrode(s) break, fall off and/or produce electrical arcing that could initiate a fire which may damage the EAF components in the manufacturing setting. Accordingly, certain embodiments of the invention provide a desirable safety enhancement and electrode-life enhancement for the operation of an EAF.

In accordance with certain embodiments of the invention, for example, the EVDM comprises a computer processor configured to receive waveform signals corresponding to voltage values and current values associated with an electrode voltage measured between the electrode and the bottom of the EAF shell (electrode voltage) and the electrical current passing through the electrode, and define an EVDM queue having a EVDM queue length based upon an EVDM window time and a sample frequency. In accordance with certain embodiments of the invention, the EVDM window time may be a predefined time period or a user selected time period over which individual samples of the waveform signals are received and/or ascertained. The EVDM may also include one or more sub-modules (e.g., alarm modes) that are selectable by a user, the one or more sub-modules being configured to trigger an internal alarm occurrence (IAO) associated with electrode vibration detection based on a comparison performed in the computer processor of (i) the individual samples of the RMS values and (ii) one or more predefined electrical profiles associated with electrode vibration detection. In accordance with certain embodiments of the invention, the one or more sub-modules may be configured to produce vibration data for each individual sample defined as being either a respective IAO or a respective non-internal alarm occurrence (NIAO). The computer processor may further be configured to accumulate the vibration data for each individual sample from the one or more sub-modules until the EVDM queue length is full, and trigger an external vibration alarm (EVA) if a minimum percentage of the vibration data is defined as being comprised of respective IAOs.

In accordance with certain embodiments of the invention, the minimum percentage required to trigger the EVA is selectable or defined by a user, such as via a user interface and optionally identified as an "ON WINDOW %" entry location on the user interface. For example, the minimum percentage required to trigger the EVA may be adjusted by a user (e.g., an operator) and/or input and locked by plant management to ensure consistency in operating parameters among different shifts. In accordance with certain embodiments of the invention, the minimum percentage required to trigger the EVA ranges from 10% to about 100%, such as at least about any of the following: 10, 15, 20, 25, 30, 35, 40, 45, and 50%, and/or at most about any of the following: 100, 90, 80, 70, 60, and 50%.

The EVDM window time, in accordance with certain embodiments of the invention, may be selected or defined by a user, such as via a user interface. For example, the EVDM window time may be adjusted by a user (e.g., an operator) and/or input and locked by plant management to ensure consistency in operating parameters among different shifts. In accordance with certain embodiments of the invention, the EVDM window time may comprise from about 500 milliseconds (ms) to about 5000 ms, such as at least about any of the following: 500, 800, 1000, 1200, 1500, 1800, 2000, 2200, and 2500 ms, and/or at most about any of the following: 5000, 4500, 4000, 3500, 3000, 2800, and 2500 ms. Additionally or alternatively, the sampling frequency may be 120, 100, 60 or 50 Hz according to the AC power system frequency with a preferred value of 120 Hz for 60 Hz AC systems and 100 Hz for 50 Hz AC systems.

In accordance with certain embodiments of the invention, the EVDM window time may comprise a rolling EVDM window time, in which the EVDM inserts a new sample and removes the oldest sample to maintain the queue length filled with the last samples at the time. When the electrical profile is changed the EVDM discards the current queue data and initiates population of a new EVDM queue. In accordance with certain embodiments of the invention, the rolling EVDM window time may include a plurality of successive individual EVDM data that may be the same or different from each other.

In accordance with certain embodiments of the invention, the computer processor of the EVDM may be further configured to turn off the EVA if vibration data has a percentage of respective IAOs below a predefined maximum percentage, in which the predefined maximum percentage is lower than the minimum percentage of the vibration data required to trigger the EVA. In this regard, the EVDM may not only trigger an alarm when unacceptable electrode vibration is detected, but may also disable such an alarm once operation of the electrode(s) has adequately addressed the operating conditions leading to the electrode vibration. In accordance with certain embodiments of the invention, the predefined maximum percentage required to turn off the EVA may be selectable or defined by a user, such as via the user interface and optionally identified as an "OFF WINDOW %" entry location on the user interface. For example, the predefined maximum percentage required to turn off the EVA may be adjusted by a user (e.g., an operator) and/or input and locked by plant management to ensure consistency in operating parameters among different shifts. In accordance with certain embodiments of the invention, the predefined maximum percentage required to turn off the EVA may range from 5% to about 50%, such as at least about any of the following: 5, 10, 20, and 25%, and/or at most about any of the following: 50, 45, 40, 35, 30, and 25%.

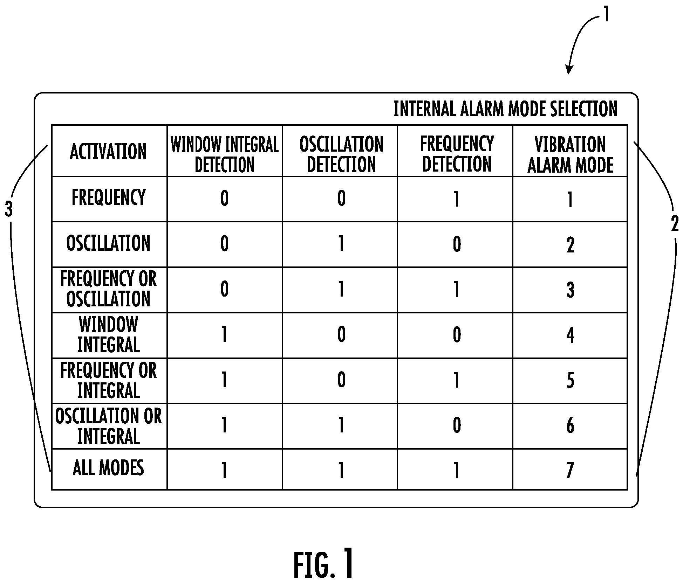

In accordance with certain embodiments of the invention, a plurality of the one or more sub-modules (e.g., alarm modes) may be simultaneously selected (e.g., selected at the same time or in an overlapping fashion, in which a first alarm mode is initially selected and subsequently a second alarm mode is further selected). In this regard, a plurality of the one or more sub-modules may be selectable at the same or overlapping time period during operation of the electrode(s). The one or more sub-modules selectable by a user, for example, may be performed via a user interface, wherein optionally each of the one or more sub-modules are identified as a respective "ALARM MODE" selection location on the user interface. Figure 1, for instance, illustrates an example user interface 1 for the selection of the one or more sub-modules (e.g., internal alarm(s)), in which a variety of Vibration Alarm Mode variations 2 may be selected corresponding to the various combinations of individual sub-modules (e.g., internal alarm modes) 3.

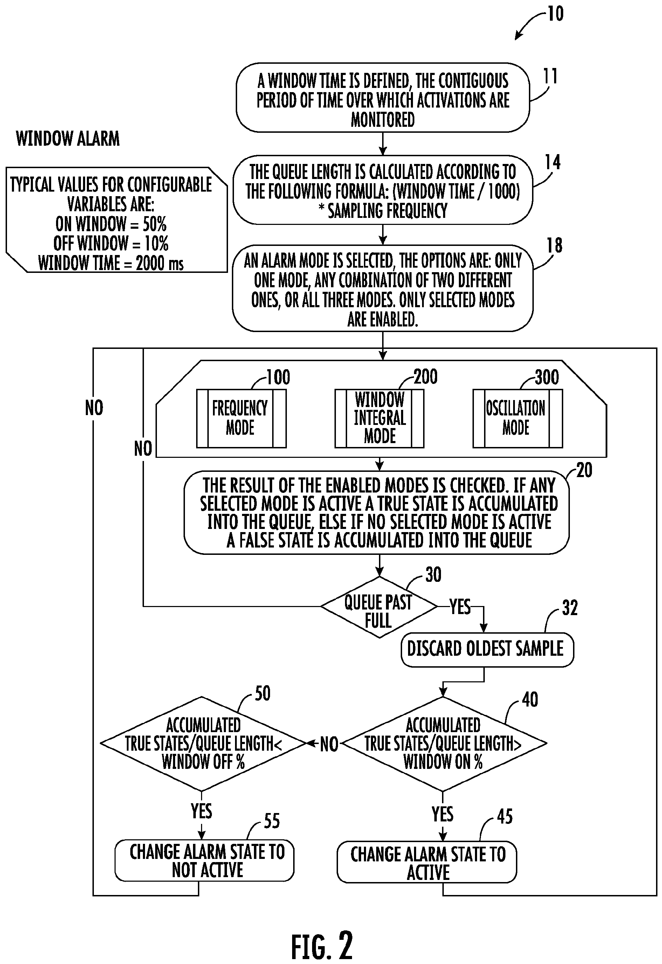

Figure 2 illustrates a flow diagram 10 for the operation of an EVDM in accordance with certain non-limiting embodiments of the invention. As illustrated by Figure 2, a EVDM window time is defined by a user in milliseconds 11, and an EVDM queue length is calculated 14 by the computer processor, wherein the '1000' in the equation on Figure 2 is for converting from milliseconds to second. As noted above, one or more alarm modes (e.g., sub-modules) may be selected by a user 18. Figure 2 illustrates an embodiment in which the EVDM includes three sub-modules (e.g., internal alarms) 100, 200, 300. The one or more sub-modules 100, 200, 300 as disclosed and described herein may be configured to trigger an internal alarm occurrence (IAO) associated with electrode vibration detection based on a comparison performed in the computer processor of (i) the individual samples of the RMS values and (ii) one or more predefined electrical profiles associated with electrode vibration detection. In this regard, the one or more sub-modules 100, 200, 300 may be configured to produce vibration data for each individual sample defined as being either a respective IAO or a respective non-internal alarm occurrence (NIAO) 20. The computer processor may be further configured to accumulate the vibration data for each individual sample from the one or more sub-modules until the EVDM queue length grew past full 30, discarding the oldest samples in that case 32), determine if the accumulated number of IAOs of the given EVDM queue length is above a minimum threshold 40 to trigger an external vibration alarm (EVA) 45 (e.g., if a minimum percentage of the vibration data is defined as being comprised of respective IAOs). As also illustrated in Figure 2, the computer processor of the EVDM may be configured to determine if the accumulated number of IAOs of the given EVDM queue length is below a predetermined maximum threshold 50 to turn off the EVA 55.

In accordance with certain embodiments of the invention, the one or more sub-modules (e.g., internal alarm modes) includes a first sub-module configured to detect frequency (e.g., frequency mode 100 from Figure 1) components inside a defined frequency range having a minimum frequency value and a maximum frequency value of the one or more predefined electrical profiles associated with electrode vibration detection. For example, the first sub-module may be configured to (i) define a set of non-filtered electrical values, such as respective current, voltage, calculated impedance, and/or calculated admittance values, from the waveform signals corresponding to voltage values and current values, and their corresponding RMS values, associated with an electrode voltage measured between the electrode and the bottom of the EAF shell (electrode voltage) and the electrical current passing through the electrode, (ii) define filtered signals for each sample RMS value to define a set of filtered electrical values, such as respective filtered current, voltage, calculated impedance, and/or calculated admittance values, from the waveform signals corresponding to voltage values and current values, and their corresponding RMS values, associated with an electrode voltage measured between the electrode and the bottom of the EAF shell (electrode voltage) and the electrical current passing through the electrode that have been filtered through a band pass filter configured to filter out any frequencies outside of the defined frequency range, (iii) determine for each sample a respective ratio between one or more respective filtered electrical properties and corresponding one or more non-filtered electrical properties in the computer processor, and (iv) trigger an IAO associated with electrode vibration detection for each respective ratio above a predefined threshold value. The predefined threshold value, for example, may be selectable or defined by a user, such as via the user interface. By way of example only, the predefined threshold value is above about 10%, such as at least about any of the following: 10, 13, 15, 17, 20, 25, 30, 33, 35, 38, 40, 45, 50, 55, 60, 65, 70, 75, 80, 85, 90 and 95%.

The defined frequency range, for example, may be defined by the use of one or more digital band pass filters. The defined frequency range configured by the one or more digital band pass filters may comprise from about 1 to about 10 Hertz (Hz), wherein the minimum frequency value comprises at least about any of the following: 1, 1.2, 1.4, 1.6, 1.8, 2, 2.2, 2.4, 2.6, 2.8, 3, 3.2, 3.4, 3.6, 3.8, 4, 4.2, 4.4, 4.6, 4.8, and 5 Hz, and the maximum frequency value comprises from at most about any of the following: 10, 9.5, 9, 8.5, 8, 7.5, 7, 6.5, 6, 5.5, and 5 Hz. In accordance with certain embodiments of the invention, the non-filtered electrical values and the filtered electrical values are impedance root-mean-square (RMS) and admittance RMS. The EVDM, in accordance with certain embodiments of the invention, has or may be further configured to receive a minimum impedance RMS threshold, and the filtered impedance RMS value must exceed the minimum impedance RMS threshold to allow the EVDM to trigger an IAO.

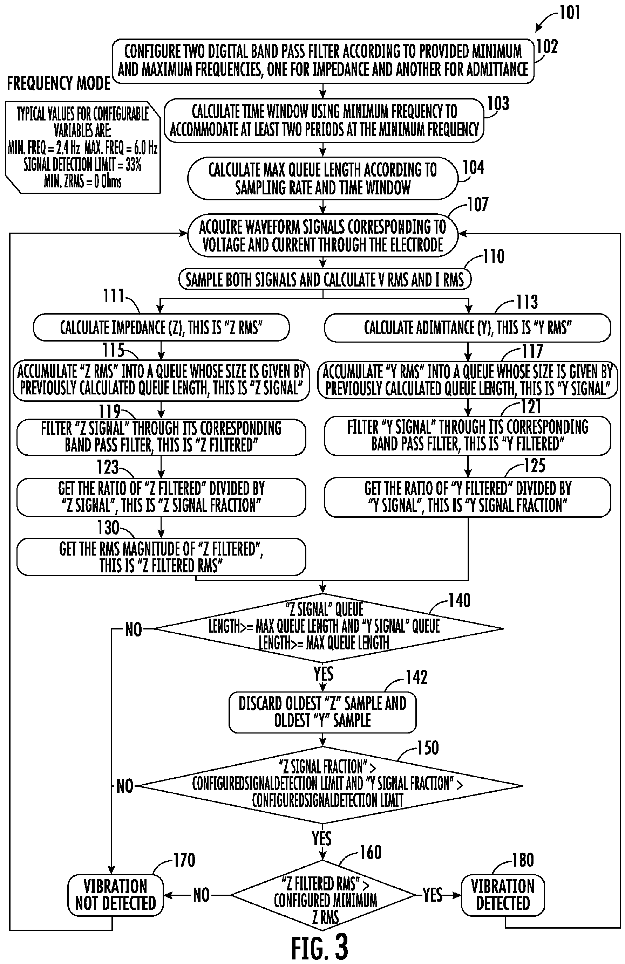

Figure 3 illustrates a flow diagram 101 for the operation of the first sub-module 100 of an EVDM in accordance with certain non-limiting embodiments of the invention. As illustrated by Figure 3, the first sub-module 100 may include two digital band pass filters 102 configured to provide a predefined frequency window having a minimum frequency and a maximum frequency. Frequencies outside of the predefined frequency window will be filtered out. As illustrated in Figure 3, one digital band pass filter is provided for the analysis of impedance and another band pass filter is provided for the analysis of admittance as noted below. The first sub-module 100 may be configured to calculate (e.g., in a computer processor) a first sub-module time window using the band pass filter minimum frequency to accommodate at least two periods at the minimum frequency 103, and calculate (e.g., in a computer processor) a first sub-module maximum queue length of a first sub-module queue based on the first sub-module time window and a sampling rate of the first sub-module 104. As noted above, the first sub-module may be configured to acquire waveform signals corresponding to the voltage and current values associated with the electrode(s) for each sample during the first sub-module time window 107. Via the computer processor, the first sub-module may be configured to sample both signals and calculate the voltage-RMS and the current-RMS 110. In the embodiment illustrated in Figure 3, the first sub-system calculates the impedance (e.g., impedance-RMS) in the computer processor 111, accumulates the impedance-RMS values into the first sub-module queue 115 to provide "Z signal" values, filter the "Z signal" through its corresponding digital band pass filter to provide "Z Filtered" values 119, calculate a ratio between the "Z Filtered" values and the "Z signal" values to provide "Z Signal Fraction" values 123, and determine the RMS magnitude of the "Z Filtered" values to provide "Z Filtered RMS" values 130. Additionally, the first sub-system calculates the admittance (e.g., admittance-RMS) in the computer processor 113, accumulates the admittance-RMS values into the first sub-module queue 117 to provide "Y signal" values, filter the "Y signal" through its corresponding digital band pass filter to provide "Y Filtered" values 121, calculate a ratio between the "Y Filtered" values and the "Y signal" values to provide "Y Signal Fraction" values 125. In accordance with certain embodiments of the invention, the first sub-module may be configured to keep accumulating samples if the number of "Z Signal" values and "Y Signal" values, discarding the oldest samples when the queue is full to maintain the queue length at or below the maximum queue length as determined in the computer processor. If the accumulated number of "Z Signal" values and "Y Signal" values are each at or above the first sub-module maximum queue length, then the computer processor compares the "Z Signal Fraction" to the configured signal detection limit (e.g., a predefined threshold value) and compares the "Y Signal Fraction" to the configured signal detection limit (e.g., the predefined threshold value) 150. If the "Z Signal Fraction" and/or the "Y Signal Fraction" do not exceed the configured signal detection limit (e.g., the predefined threshold value) then a vibration is not detected. However, if each of the "Z Signal Fraction" and the "Y Signal Fraction" exceed the configured signal detection limit (e.g., the predefined threshold value), then the computer processor determines if the "Z filtered RMS" value exceeds the configured minimum impedance RMS value 160, which may be selected or defined by a user via, for example, a user interface. In order for a vibration to be detected 180 (e.g., and trigger of an IAO), each of operations 140, 150, and 160 must be affirmative determinations. Optional operation 142 may include discarding oldest "Z" sample and oldest "Y" sample. In this regard, if any of operations 140, 150, or 160 provide a negative determination, then a vibration for this given sample will not be detected 170.

In accordance with certain embodiments of the invention, the one or more sub-modules (e.g., internal alarm modes) includes a second sub-module configured to detect and count the number of open circuit samples and/or the number of short circuit samples based upon the calculated impedance-RMS values for each individual sample, wherein an individual open circuit sample is defined as a having an impedance-RMS above an open circuit threshold that may optionally be set by a user, for example, 30, 35 or 40 milliohms, and wherein an individual short circuit sample is defined as a having an impedance-RMS below a short circuit threshold, for example 7, 6, 5, 4, 3 or 2 milliohms, depending on the EAF transformer secondary circuit that may optionally be set by a user, for example, via a user interface.

The second sub-module, in accordance with certain embodiments of the invention, may comprise a second sub-module-queue having a second queue length. The second sub-module may be configured to accumulate individual samples of the calculated impedance-RMS values for each sample until the second sub-module-queue is full, discarding oldest samples to maintain the queue full at the maximum queue length thus keeping the last samples at the time. The length or number of samples required to fill the second queue length can be calculated in the computer processor in any manner described herein for the general calculation of a queue length. In accordance with certain embodiments of the invention, the second sub-module may further be configured to (i) determine the percentage of individual open circuit samples from the second sub-module-queue and the percentage of individual short circuit samples from the second sub-module-queue in the computer processor , (ii) determine if the percentage of individual open circuit samples from the second sub-module-queue exceeds a threshold percentage for open circuit occurrences in the computer processor; and (iii) determine if the percentage of individual short circuit samples from the second sub-module-queue exceeds a threshold percentage for short circuit occurrences in the computer processor. In accordance with certain embodiments of the invention, the second sub-module may be further configured to trigger an IAO associated with electrode vibration detection for each sample having (i) a determined percentage of individual open circuit samples from the second sub-module-queue exceeds a threshold percentage for open circuit occurrences in the computer processor and (ii) a determined percentage of individual short circuit samples from the second sub-module-queue exceeds a threshold percentage for short circuit occurrences in the computer processor.

As noted above, the second queue length may be determined in the computer processor based on a sampling time window of the second sub-module multiplied by a sampling frequency of the second sub-module. In this regard, the sampling time window of the second sub-module may be selected or defined by a user, such as via the user interface. By way of example only, the sampling time window may comprise from 1 to about 8 seconds, such as at least about any of the following: 1, 2, 3, and 4 seconds, and/or at most about 8, 7, 6, 5, and 4 seconds. Additionally or alternatively, the sampling frequency of the second sub-module is the same as the RMS sampling frequency.

In accordance with certain embodiments of the invention, the threshold percentage for open circuit occurrences may comprise from about 20% to about 50%, such as at least about any of the following: 20, 25, 30 and 35%, and/or at most about any of the following: 50, 45, 40 and 35%. Additionally or alternatively, the threshold percentage for short circuit occurrences is from about 20% to about 50%, such as at least about any of the following: 20, 25, 30 and 35% and/or at most about any of the following: 50, 45, 40 and 35%.

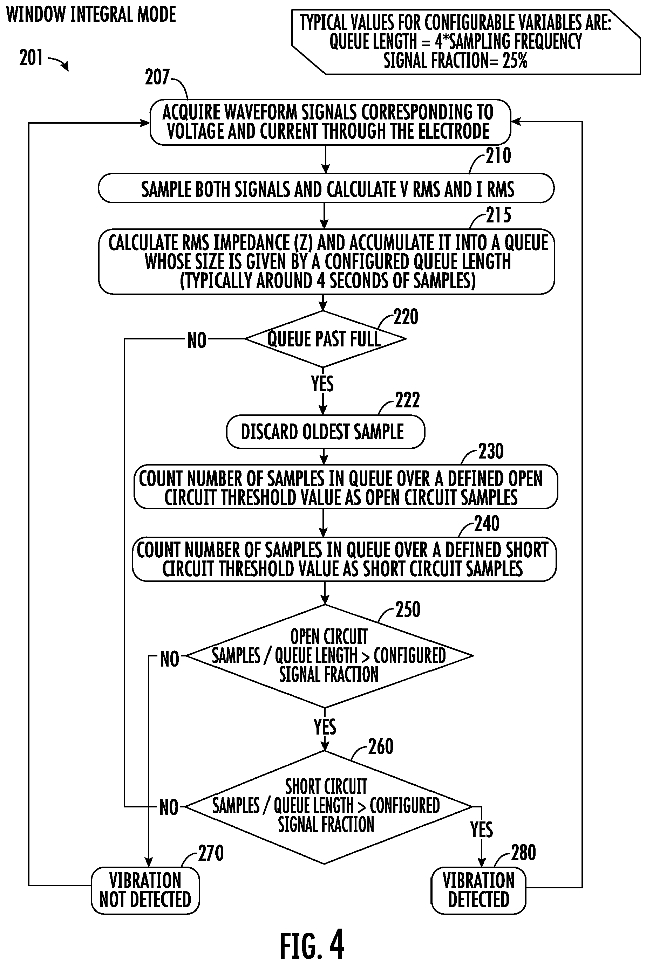

Figure 4 illustrates a flow diagram 201 for the operation of a second sub-module (e.g., internal alarm mode) 200 of an EVDM in accordance with certain embodiments of the invention. As illustrated in Figure 4, the second sub-module 200 may be configured to acquire waveform signals corresponding to the voltage and current values associated with the electrode(s) for each sample during the second sub-module time window 207. Via the computer processor, the second sub-module may be configured to sample both signals and calculate the voltage-RMS and the current-RMS values for each sample 210. The second sub-module may further be configured to calculate the impedance-RMS values for each sample and accumulate these values into the second sub-module queue, which may have a second queue length calculated from the sample time period (second time window) and the sampling frequency, in the computer processor. The accumulated impedance-RMS values for each samples may be loaded and/or maintained in the second sub-module queue until the second queue length has been reached, discarding oldest values to maintain the queue full at the maximum queue length 220. Next, the second sub-module may be configured to count the number or samples (e.g., impedance-RMS values for each sample) in the second sub-module queue that have an impedance-RMS value exceeding a defined impedance-RMS threshold value (e.g., user defined and/or selected) identifying the individual sample as representing an open circuit sample 230. Additionally, the second sub-module may be configured to count the number or samples (e.g., impedance-RMS values for each sample) in the second sub-module queue that have an impedance-RMS value below a defined impedance-RMS threshold value (e.g., user defined and/or selected) identifying the individual sample as representing a short circuit sample 240. As shown in Figure 4, the second sub-module may be configured to determine the percentage of individual open circuit samples from the second sub-module-queue and calculate if this percentage exceeds a user selected or defined configured signal fraction (e.g., threshold percentage for open circuit occurrences) representative of electrode vibration in the computer processor 250. Additionally, the second sub-module may be configured to determine the percentage of individual short circuit samples from the second sub-module-queue and calculate if this percentage exceeds a user selected or defined configured signal fraction (e.g., threshold percentage for short circuit occurrences) representative of electrode vibration in the computer processor 260. The second sub-module may further be configured to trigger an IAO (e.g., vibration detected) 280 if the percentage of individual open circuit samples exceeds a user selected or defined configured signal fraction (e.g., threshold percentage for open circuit occurrences) representative of electrode vibration in the computer processor 250 and if the percentage of individual short circuit samples exceeds a user selected or defined configured signal fraction (e.g., threshold percentage for short circuit occurrences) representative of electrode vibration in the computer processor. If at least one of operations 250 and 260 are not determined to exceed the respective configured signal fraction, then no vibration is detected 270.

In accordance with certain embodiments of the invention, the one or more sub-modules (e.g., internal alarm modes) includes a third sub-module configured to detect and count a total number of state changes between a short circuit and an open circuit in the computer processor. In accordance with certain embodiments of the invention, the third sub-module may be further configured to compare the total number of state changes to a user defined state-change threshold in the computer processor and trigger an IAO associated with electrode vibration detection if the total number of state changes exceeds the user defined state-change threshold via the computer processor. The third sub-module, for example, will be referred to as the "oscillation mode".

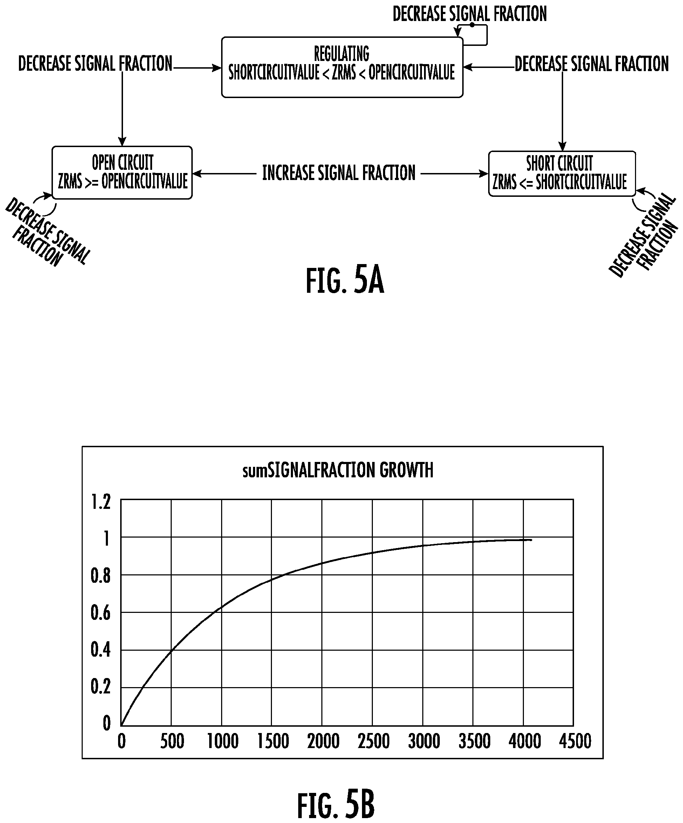

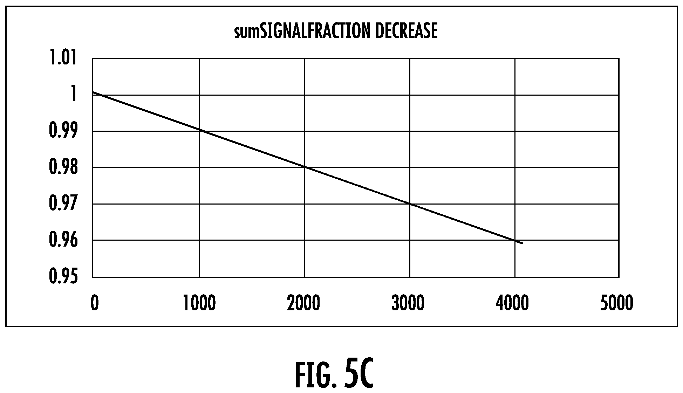

In accordance with certain embodiments of the invention, the oscillation mode (e.g., third sub-module) works like a finite state machine (FSM), and contains three (3) states: (i) regulating, (ii) short-circuit, and (iii) open circuit. Every time there is a switch between short circuit and open circuit states, or vice versa, without passing through regulating state, the third sub-module increments a variable called sumSignalFraction by a dynamic value calculated as the proportion of the difference from the previous sumSignalFraction value to the unit causing the variable to approach the unit in a negative exponential decay behavior. Every entry into the regulating state or maintain the current state, the third sub-module decrements the variable by a constant factor determined by the variable "downslope". Figure 5A illustrates a graphic illustration of the concept. Figure 5B is the growth of the variable using upProportion = 0.001, which approaches 1.0 in a negative exponential decay behavior in that it has a rapid growth that gradually slows down converging to 1.0. As mentioned above, all of this assumes that the system does not go into "regulating" state. If the system goes into regulating state or if it remains in the current state, then the variable has a constant downward slope illustrated by Figure 5C. As the other alarms, when the signal fraction exceeds the configured activation threshold, vibration is detected.

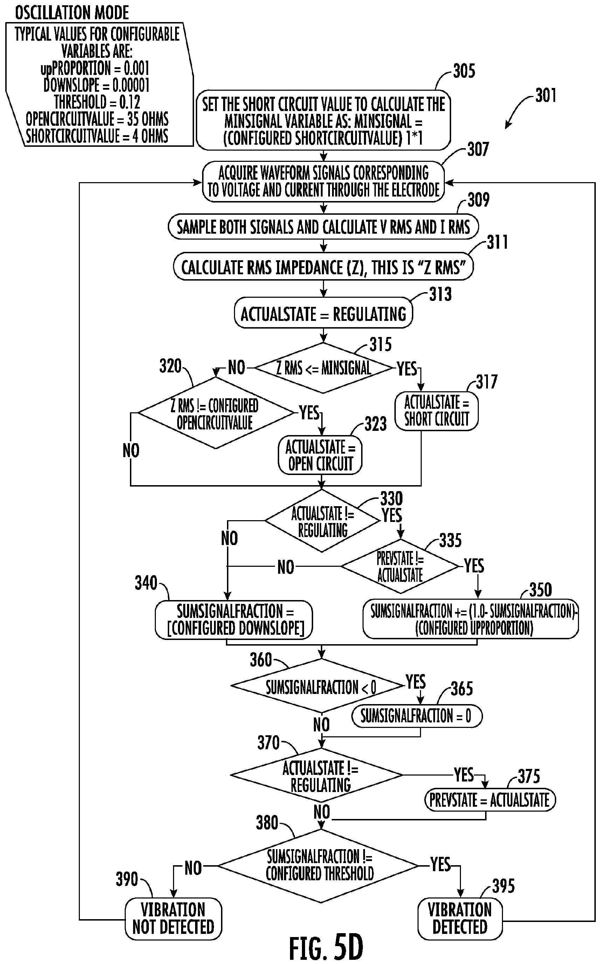

Figure 5D illustrates a flow diagram 301 for the operation of a third sub-module 300 (e.g., internal alarm mode) of an EVDM in accordance with certain embodiments of the invention. In Figure 5D, the word "configured" is used to denote that the variable is received through a configuration model that the user previously personalized. "Actual state" means the current state in the Finite state machine (FSM) between the three alternatives: regulating, open circuit, short circuit. The ranges for the configurable variables are in the following format:
Configured Variable [ Lower Limit - Upper Limit];
upProportion [0.0001 - 0.01 ] The dynamic proportion rate at which signalFraction grows towards one;
downSlope [0.000001 - 0.0001] The constant rate at which signalFraction decreases
threshold [0 - 1 ] Activation threshold to determine if there is vibration (IAO);
openCircuitValue [30 - 45 ] Value compared to Zrms to check if the system is in an open circuit state; and
shortCircuitValue [2 - 10 ] Value compared to Zrms to check if the system is in a short circuit state.

As shown in Figure 5D, a short circuit value is set to calculate the minSignal variable 305, followed by acquiring waveform signals corresponding to current and voltage through the electrode 307. The third sub-module samples both signals and calculated Vrms and Irms 309. Next, the impedance RMS (Zrms) is calculated 311 using the values from 309. The Zrms is compared to the minSignal 315 and if Zrms is less than the minSignal then the actual state is determined to be a short circuit 317, while if the Zrms is greater than the minSignal then the actual state is evaluated with respect to the configured opencircuitValue, the outcome of which determines the actual state to be an open circuit. A determination if the actualState is different than regulating 330, and if it is different, then a determination if the prevState is different than the actualState 335. In this regard, the operator "!=" shown in Figure 5D is understood in the art as an operator that checks for inequality. If so, then the sumSignalFraction configured upProportion is applied 350 otherwise if the actual state is regulating or if the previous state is the same as the actual state, then the configured downslope is applied 340. The sumSignalFraction is compared to be less than the value of zero 360, the outcome of which determines if the sumSignalFraction is reset to zero 365. If the actual state is regulating then the actualState is assigned to the prevState variable 375. A vibration is not detected 390 or detected 395, based on operations 360, 365, 370, 375 and 380 shown in Figure 5D.

In another aspect, the present invention provides methods of detecting vibration of an electrode (e.g., one or more electrodes) of an EAF, in which the method may comprise the following steps: (a) providing an EVDM, such as those described and disclosed herein, in operative communication with the electrode electrical sensors and actuators; (b) receiving waveform signals corresponding to voltage values and current values associated with an electrode voltage measured between the electrode and the bottom of the EAF shell (electrode voltage) and the electrical current passing through the electrode in the computer processor of the EVDM; (c) selecting one or more sub-modules (e.g., alarm modes), in which the one or more sub-modules may be configured to trigger an internal alarm occurrence (IAO) associated with electrode vibration detection based on a comparison performed in the computer processor of (i) the individual samples of the RMS values and (ii) one or more predefined electrical profiles associated with electrode vibration detection. In accordance with certain embodiments of the invention, in which the one or more sub-modules may be configured to produce vibration data for each individual sample defined as being either a respective IAO or a respective non-internal alarm occurrence (NIAO); and (d) accumulating the vibration data for each individual sample from the one or more selected sub-modules until the EVDM queue length is full, discarding the oldest samples to maintain the queue full at the maximum queue length, and trigger an external vibration alarm (EVA) if a minimum percentage of the vibration data is defined as being comprised of respective IAOs.

In another aspect, the present invention provides a method of operating an EAF including a furnace body defining an interior portion including a refractory-lined hearth and one or more electrodes extending into the interior portion, in which the method comprises detecting vibration of the one or more electrodes, such as via a method described and disclosed herein, and adjusting a location of the one or more electrodes relative to the refractory-lined hearth by raising the one or more electrodes away from the refractory-lined hearth.

In accordance with certain embodiments of the invention, the computer processor may be configured to initiate the step of adjusting the location of the one or more electrodes relative to the refractory-lined hearth. For example, the computer processor may be further configured to vary the rate and/or distance of the one or more electrodes based on the number of heats of the one or more electrodes, wherein the number of heats may be understood as the number of batches for which the one or more electrodes has been used for melting scrap metal. Additionally or alternatively, the computer processor may be configured to initiate the step of adjusting the location of the one or more electrodes relative to the refractory-lined hearth at a first rate and/or first distance when the number of heats of the one or more electrodes is below a user defined heat number threshold (e.g., below 5, 4, 3, or 2 heats), and a second rate and/or second distance when the number of heats of the one or more electrodes is above a user defined heat number threshold (e.g., about 1, 2, 3, 4, or 5 heats), in which the first rate is greater than the second rate and the first distance is greater than the second distance.

In yet another aspect, the present invention provides an EAF system comprising (i) an EAF including a furnace body defining an interior portion including a refractory-lined hearth and one or more electrodes extending into the interior portion; and (ii) an electrode vibration detection module (EVDM) such as those described and disclosed herein. In accordance with certain embodiments of the invention, the EVDM may be in operative communication with the one or more electrodes' electrical sensors and actuators.

These and other modifications and variations to embodiments of the invention may be practiced by those of ordinary skill in the art without departing from the spirit and scope of the invention, which is more particularly set forth in the appended claims. In addition, it should be understood that aspects of the various embodiments may be interchanged in whole or in part. Furthermore, those of ordinary skill in the art will appreciate that the foregoing description is by way of example only, and it is not intended to limit the invention as further described in such appended claims. Therefore, the spirit and scope of the appended claims should not be limited to the exemplary description of the versions contained herein.

In the following list embodiments are disclosed that may also be claimed, in particular by replacing the word "embodiment" by the word "claim".

Embodiment 1. An electrode vibration detection module (EVDM) in operative communication with an electrode electric sensor and electrode actuator of an electric arc furnace (EAF), comprising:
(a) a computer processor configured to: (i) receive waveform signals corresponding to voltage values and current values associated with an electrode voltage measured between the electrode and the bottom of the EAF shell (electrode voltage) and the electrical current passing through the electrode; and (ii) define an EVDM queue having a EVDM queue length based upon an EVDM window time and a sampling frequency, wherein the EVDM window time is a predefined time period or a user selected time period over which individual samples of the waveform signals are received and/or ascertained and their root mean square values (RMS values) calculated every sampling period, such as every half cycle of the electrical power system;
(b) one or more sub-modules selectable by a user, the one or more sub-modules being configured to trigger an internal alarm occurrence (IAO) associated with electrode vibration detection based on a comparison performed in the computer processor of (i) the individual samples of the RMS values and (ii) one or more predefined electrical profiles associated with electrode vibration detection; wherein the one or more sub-modules being configured to produce vibration data for each individual sample defined as being either a respective IAO or a respective non-internal alarm occurrence (NIAO); and
(c) the computer processor being further configured to accumulate the vibration data for each individual sample from the one or more sub-modules stored in a queue, and trigger an external vibration alarm (EVA) if a minimum percentage of the vibration data is defined as being comprised of respective IAOs.

Embodiment 2. The EVDM of embodiment 1, wherein the minimum percentage required to trigger the EVA is selectable or defined by a user, such as via a user interface and optionally identified as an "ON WINDOW %" entry location on the user interface.

Embodiment 3. The EVDM of embodiment 2, wherein the minimum percentage ranges from 10% to about 100%, such as at least about any of the following: 10, 15, 20, 25, 30, 35, 40, 45, and 50%, and/or at most about any of the following: 100, 90, 80, 70, 60, and 50%.

Embodiment 4. The EVDM of embodiments 1-3, wherein the EVDM window time may comprise from about 500 milliseconds (ms) to about 5000 ms, such as at least about any of the following: 500, 800, 1000, 1200, 1500, 1800, 2000, 2200, and 2500 ms, and/or at most about any of the following: 5000, 4500, 4000, 3500, 3000, 2800, and 2500 ms.

Embodiment 5. The EVDM of embodiments 1-4, wherein the sampling frequency is greater than 10 Hz or is related to the electrical power system frequency but not limited to these frequencies, such as 100 Hz for 50 Hz power systems or 120 Hz for 60 Hz power systems.

Embodiment 6. The EVDM of embodiments 1-5, wherein EVDM window time is a rolling EVDM window time and the EVDM initiates population of a respective new EVDM queue after an electrical profile is changed with vibration data from the one or more sub-modules.

Embodiment 7. The EVDM of embodiments 1-6, wherein the computer processor is further configured to turn off the EVA if vibration data has a percentage of respective IAOs below a predefined maximum percentage, the predefined maximum percentage being lower than the minimum percentage of the vibration data required to trigger the EVA.

Embodiment 8. The EVDM of embodiment 7, wherein the predefined maximum percentage required to turn off the EVA is selectable or defined by a user, such as via the user interface and optionally identified as an "OFF WINDOW %" entry location on the user interface.

Embodiment 9. The EVDM of embodiment 8, wherein the predefined maximum percentage ranges from 5% to about 50%, such as at least about any of the following: 5, 10, 20, and 25%, and/or at most about any of the following: 50, 45, 40, 35, 30, and 25%.

Embodiment 10. The EVDM of embodiments 1-9, wherein a plurality of the one or more sub-modules are selectable at the same or overlapping time period during operation of the EAF.

Embodiment 11. The EVDM of embodiments 1-10, wherein the one or more sub-modules selectable by a user is performed via a user interface, wherein optionally each of the one or more sub-modules are identified as a respective "ALARM MODE" selection location on the user interface.

Embodiment 12. The EVDM of embodiments 1-11, wherein the one or more sub-modules includes a first sub-module configured to detect frequency components inside a defined frequency range having a minimum frequency value and a maximum frequency value of the one or more predefined electrical profiles associated with electrode vibration detection.

Embodiment 13. The EVDM of embodiment 12, wherein the first sub-module is configured to (i) define a set of non-filtered electrical values, such as respective current, voltage, impedance, and/or admittance RMS values, calculated from the waveform signals corresponding to voltage values and current values associated with an electrode voltage measured between the electrode and the bottom of the EAF shell (electrode voltage) and the electrical current passing through the electrode, (ii) define filtered signals for each sample to define a set of filtered electrical values, such as respective filtered current, voltage, impedance, and/or admittance values, from the signals corresponding to voltage values and current values associated with an electrode voltage measured between the electrode and the bottom of the EAF shell (electrode voltage) and the electrical current passing through the electrode that have been filtered through a band pass filter configured to filter out any frequencies outside of the defined frequency range to provide (iii) determining for each sample a respective ratio between one or more respective filtered electrical properties and corresponding one or more non-filtered electrical properties in the computer processor, and (iv) triggering an IAO associated with electrode vibration detection for each respective ratio above a predefined threshold value.

Embodiment 14. The EVDM of embodiments 12-13, wherein the defined frequency range comprises from about 1 to about 10 Hertz (Hz), wherein the minimum frequency value comprises at least about any of the following: 1, 1.2, 1.4, 1.6, 1.8, 2, 2.2, 2.4, 2.6, 2.8, 3, 3.2, 3.4, 3.6, 3.8, 4, 4.2, 4.4, 4.6, 4.8 and 5 Hz, and the maximum frequency value comprises from at most about any of the following: 10, 9.5, 9, 8.5, 8, 7.5, 7, 6.5, 6, 5.5 and 5 Hz.

Embodiment 15. The EVDM of embodiments 13-14, wherein the non-filtered electrical values and the filtered electrical values are impedance root-mean-square (RMS) and admittance RMS.

Embodiment 16. The EVDM of embodiments 13-15, wherein the predefined threshold value is selectable or defined by a user, such as via the user interface.

Embodiment 17. The EVDM of embodiments 13-16, wherein the predefined threshold value is above about 10%, such as at least about any of the following: 10, 13, 15, 17, 20, 25, 30, 33, 35, 38, 40, 45, 50, 55, 60, 65, 70, 75, 80, 85, 90 and 95%.

Embodiment 18. The EVDM of embodiments 15-17, wherein the EVDM has or is further configured to receive a minimum impedance RMS threshold, and the filtered impedance RMS value must exceed the minimum impedance RMS threshold to allow the EVDM to trigger an IAO.

Embodiment 19. The EVDM of embodiments 1-11, wherein the one or more sub-modules includes a second sub-module configured to detect and count the number of open circuit samples and/or the number of short circuit samples based upon the calculated impedance-RMS values for each individual sample; wherein an individual open circuit sample is defined as a having an impedance-RMS above an open circuit threshold that may optionally be set by a user, such as 30, 35 or 40 milliohms, and wherein an individual short circuit sample is defined as a having an impedance-RMS below a short circuit threshold, such as 7, 6, 5, 4, 3 or 2 milliohms that may optionally be set by a user.

Embodiment 20. The EVDM of embodiment 19, wherein the second sub-module comprises a second sub-module- queue having a second queue length, the second sub-module configured to accumulate individual samples of the calculated impedance-RMS, discarding the oldest samples to maintain the queue full at the maximum queue length, the second sub-module is further configured to (i) determine the percentage of individual open circuit samples from the second sub-module-queue and the percentage of individual short circuit samples from the second sub-module- queue in the computer processor , (ii) determine if the percentage of individual open circuit samples from the second sub-module-queue exceeds a threshold percentage for open circuit occurrences in the computer processor; and (iii) determine if the percentage of individual short circuit samples from the second sub-module-queue exceeds a threshold percentage for short circuit occurrences in the computer processor.

Embodiment 21. The EVDM of embodiment 20, wherein the computer processor is further configured to trigger an IAO associated with electrode vibration detection for each sample having (i) a determined percentage of individual open circuit samples from the second sub-module-queue exceeds a threshold percentage for open circuit occurrences in the computer processor and (ii) a determined percentage of individual short circuit samples from the second sub-module-queue exceeds a threshold percentage for short circuit occurrences in the computer processor.

Embodiment 22. The EVDM of embodiments 20-21, wherein the second queue length is determined in the computer processor based on a sampling time window of the second sub-module.

Embodiment 23. The EVDM of embodiment 22, wherein the sampling time window is from 1 to about 8 seconds, such as at least about any of the following: 1, 2, 3, and 4 seconds, and/or at most about 8, 7, 6, 5, and 4 seconds.

Embodiment 24. The EVDM of embodiments 22-23, wherein the sampling frequency of the second sub-module is greater than 10 Hz or is related to the electrical power system frequency but not limited to these frequencies, such as 100 Hz for 50 Hz power systems or 120 Hz for 60 Hz power systems.

Embodiment 25. The EVDM of embodiments 22-24, wherein the threshold percentage for open circuit occurrences is from about 20% to about 50%, such as at least about any of the following: 20, 25, 30 and 35%, and/or at most about any of the following: 50, 45, 40 and 35%.

Embodiment 26. The EVDM of embodiments 22-25, wherein the threshold percentage for short circuit occurrences is from about 20% to about 50%, such as at least about any of the following: 20, 25, 30 and 35%, and/or at most about any of the following: 50, 45, 40 and 35%.

Embodiment 27. The EVDM of embodiments 1-11, wherein the one or more sub-modules includes a third sub-module configured to detect and count a total number of state changes between a short circuit and an open circuit in the computer processor and wherein the third sub-module is further configured to (i) determine if the current state in the Finite state machine (current state) is the same as "Regulating" state, (ii) determine if the current state is the same as the previous state in the state machine, (iii) increase or decrease the cumulative variable accordingly and (iv) determine if the total number of state changes exceeds a threshold for state changes occurrences in the computer processor.

Embodiment 28. The EVDM of embodiment 27, wherein the computer processor is further configured to trigger an IAO associated with electrode vibration detection for each sample having a determined cumulative variable that indicates the number of state changes exceeds the user defined state-change threshold in the computer processor.

Embodiment 29. The EVDM of embodiments 27-28, wherein the sampling frequency of the third sub-module is greater than 10 Hz or is related to the electrical power system frequency but not limited to these frequencies, such as 100 Hz for 50 Hz power systems or 120 Hz for 60 Hz power systems.

Embodiment 30. The EVDM of embodiments 27-29, wherein the upProportion for increasing the cumulative variable is from about 0.0001 to about 0.01, such as at least about any of the following: 0. 0001, 0.00025, 0. 0005, 0.00075, 0.001 and/or at most about any of the following: 0.01, 0.0075, 0.0050, 0.0025 and 0.001.

Embodiment 31. The EVDM of embodiments 27-30, wherein the downslope for decreasing the cumulative variable is from is from about 0.000001 to about 0.0001, such as at least about any of the following: 0. 000001, 0.0000025, 0. 000005, 0.0000075, 0.00001 and/or at most about any of the following: 0.0001, 0.000075, 0.000050, 0.000025 and 0.00001.

Embodiment 32. The EVDM of embodiments 27-31, wherein the user defined state-change threshold for state changes occurrences is from about 0.1 to about 0.6, such as at least about any of the following: 0.10, 0.15, 0.20, 0.25, 0.30 and 0.35, and/or at most about any of the following: 0.60, 0.55, 0.50, 0.40, and 0.35.

Embodiment 33. The EVDM of embodiments 27-32, wherein the user defined openCircuitValue for comparing against Zrms to check for an open circuit state is from about 30 to 45, such as at least about any of the following: 30, 32, 34, and 38, and/or at most about any of the following: 45, 42, 40 and 38.

Embodiment 34. The EVDM of embodiments 27-33, wherein the user defined shortCircuitValue for comparing against Zrms to check for a short circuit state is from about 2 to 10, such as at least about any of the following: 2, 3, 4, 5, and 6, and/or at most about any of the following: 10, 9, 8, 7 and 6.

Embodiment 35. A method of detecting vibration of an electrode of an electric arc furnace (EAF), comprising:
(a) providing an electrode vibration detection module (EVDM) in operative communication with the electrode electrical sensors and actuators according to any one of embodiments 1-34;
(b) receiving waveform signals corresponding to voltage values and current values associated with an electrode voltage measured between the electrode and the bottom of the EAF shell (electrode voltage) and the electrical current passing through the electrode in the computer processor of the EVDM;
(c) selecting one or more sub-modules, the one or more sub-modules being configured to trigger an internal alarm occurrence (IAO) associated with electrode vibration detection based on a comparison performed in the computer processor of (i) the individual samples of the RMS values and (ii) one or more predefined electrical profiles associated with electrode vibration detection; wherein the one or more sub-modules being configured to produce vibration data for each individual sample defined as being either a respective IAO or a respective non-internal alarm occurrence (NIAO); and
(d) accumulating the vibration data for each individual sample from one or more selected sub-modules discarding the oldest samples to maintain the EVDM queue full at the maximum queue length, and trigger an external vibration alarm (EVA) if a minimum percentage of the vibration data is defined as being comprised of respective IAOs.

Embodiment 36. A method of operating an electric arc furnace (EAF) including a furnace body defining an interior portion including a refractory-lined hearth and one or more electrodes extending into the interior portion, the method comprising:
(i) detecting vibration of the one or more electrodes according to embodiment 35;
(ii) adjusting a location of the one or more electrodes relative to the refractory-lined hearth by raising the one or more electrodes away from the refractory-lined hearth.

Embodiment 37. The method of embodiment 36, wherein the computer processor is configured to initiate the step of adjusting the location of the one or more electrodes relative to the refractory-lined hearth.

Embodiment 38. The method of embodiment 37, wherein the computer processor is further configured to vary the rate and/or distance of the one or more electrodes based on the number of heats of the one or more electrodes.

Embodiment 39. The method of embodiment 38, wherein the computer processor is configured to initiate the step of adjusting the location of the one or more electrodes relative to the refractory-lined hearth at a first rate and/or first distance when the number of heats of the one or more electrodes is below a user defined heat number threshold, and a second rate and/or second distance when the number of heats of the one or more electrodes is above a user defined heat number threshold; and wherein the first rate is greater than the second rate and the first distance is greater than the second distance.

Embodiment 40. An electric arc furnace (EAF) system, comprising:
(i) an electric arc furnace (EAF) including a furnace body defining an interior portion including a refractory-lined hearth and one or more electrodes extending into the interior portion; and
(ii) an electrode vibration detection module (EVDM) according to any one of embodiments 1-34.

## Claims

1. An electrode vibration detection module (EVDM) in operative communication with an electrode electric sensor and electrode actuator of an electric arc furnace (EAF), comprising:
(a) a computer processor configured to: (i) receive waveform signals corresponding to voltage values and current values associated with an electrode voltage measured between the electrode and the bottom of the EAF shell (electrode voltage) and the electrical current passing through the electrode; and (ii) define an EVDM queue having a EVDM queue length based upon an EVDM window time and a sampling frequency, wherein the EVDM window time is a predefined time period or a user selected time period over which individual samples of the waveform signals are received and/or ascertained and their root mean square values (RMS values) calculated every sampling period, such as every half cycle of the electrical power system;
(b) one or more sub-modules selectable by a user, the one or more sub-modules being configured to trigger an internal alarm occurrence (IAO) associated with electrode vibration detection based on a comparison performed in the computer processor of (i) the individual samples of the RMS values and (ii) one or more predefined electrical profiles associated with electrode vibration detection; wherein the one or more sub-modules being configured to produce vibration data for each individual sample defined as being either a respective IAO or a respective non-internal alarm occurrence (NIAO); and
(c) the computer processor being further configured to accumulate the vibration data for each individual sample from the one or more sub-modules stored in a queue, and trigger an external vibration alarm (EVA) if a minimum percentage of the vibration data is defined as being comprised of respective IAOs.

2. The EVDM according to claim 1, wherein the minimum percentage required to trigger the EVA is selectable or defined by a user, such as via a user interface.

3. The EVDM according to claim 2, wherein
(i) the minimum percentage ranges from 10% to about 100%, such as at least about any of the following: 10, 15, 20, 25, 30, 35, 40, 45, and 50%, and/or at most about any of the following: 100, 90, 80, 70, 60, and 50%;
(ii) the EVDM window time may comprise from about 500 milliseconds (ms) to about 5000 ms, such as at least about any of the following: 500, 800, 1000, 1200, 1500, 1800, 2000, 2200, and 2500 ms, and/or at most about any of the following: 5000, 4500, 4000, 3500, 3000, 2800, and 2500 ms; and/or
(iii) the sampling frequency is greater than 10 Hz or is related to the electrical power system frequency but not limited to these frequencies, such as 100 Hz for 50 Hz power systems or 120 Hz for 60 Hz power systems.

4. The EVDM according to any of claims 1 to 3, wherein the EVDM window time is a rolling EVDM window time and the EVDM initiates population of a respective new EVDM queue after an electrical profile is changed with vibration data from the one or more sub-modules.

5. The EVDM according to any of claims 1 to 4, wherein the computer processor is further configured to turn off the EVA if vibration data has a percentage of respective IAOs below a predefined maximum percentage, the predefined maximum percentage being lower than the minimum percentage of the vibration data required to trigger the EVA.

6. The EVDM according to claim 5, wherein the predefined maximum percentage required to turn off the EVA is selectable or defined by a user.

7. The EVDM according to claim 6, wherein the predefined maximum percentage ranges from 5% to about 50%, such as at least about any of the following: 5, 10, 20, and 25%, and/or at most about any of the following: 50, 45, 40, 35, 30, and 25%.

8. The EVDM according to any of claims 1 to 7, wherein the one or more sub-modules includes a first sub-module configured to detect frequency components inside a defined frequency range having a minimum frequency value and a maximum frequency value of the one or more predefined electrical profiles associated with electrode vibration detection;
optionally, wherein the first sub-module is configured to (i) define a set of non-filtered electrical values, such as respective current, voltage, impedance, and/or admittance RMS values, calculated from the waveform signals corresponding to voltage values and current values associated with an electrode voltage measured between the electrode and the bottom of the EAF shell (electrode voltage) and the electrical current passing through the electrode, (ii) define filtered signals for each sample to define a set of filtered electrical values, such as respective filtered current, voltage, impedance, and/or admittance values, from the signals corresponding to voltage values and current values associated with an electrode voltage measured between the electrode and the bottom of the EAF shell (electrode voltage) and the electrical current passing through the electrode that have been filtered through a band pass filter configured to filter out any frequencies outside of the defined frequency range to provide (iii) determining for each sample a respective ratio between one or more respective filtered electrical properties and corresponding one or more non-filtered electrical properties in the computer processor, and (iv) triggering an IAO associated with electrode vibration detection for each respective ratio above a predefined threshold value.

9. The EVDM according to claim 8, wherein the non-filtered electrical values and the filtered electrical values are impedance root-mean-square (RMS) and admittance RMS; and/or
wherein the predefined threshold value is selectable or defined by a user, such as via the user interface; and/or
wherein the predefined threshold value is above about 10%, such as at least about any of the following: 10, 13, 15, 17, 20, 25, 30, 33, 35, 38, 40, 45, 50, 55, 60, 65, 70, 75, 80, 85, 90 and 95%; and/or
wherein the EVDM has or is further configured to receive a minimum impedance RMS threshold, and the filtered impedance RMS value must exceed the minimum impedance RMS threshold to allow the EVDM to trigger an IAO.

10. A method of detecting vibration of an electrode of an electric arc furnace (EAF), comprising:
(a) providing an electrode vibration detection module (EVDM) in operative communication with the electrode electrical sensors and actuators according to any of claims 1 to 9;
(b) receiving waveform signals corresponding to voltage values and current values associated with an electrode voltage measured between the electrode and the bottom of the EAF shell (electrode voltage) and the electrical current passing through the electrode in the computer processor of the EVDM;
(c) selecting one or more sub-modules, the one or more sub-modules being configured to trigger an internal alarm occurrence (IAO) associated with electrode vibration detection based on a comparison performed in the computer processor of (i) the individual samples of the RMS values and (ii) one or more predefined electrical profiles associated with electrode vibration detection; wherein the one or more sub-modules being configured to produce vibration data for each individual sample defined as being either a respective IAO or a respective non-internal alarm occurrence (NIAO); and
(d) accumulating the vibration data for each individual sample from one or more selected sub-modules discarding the oldest samples to maintain the EVDM queue full at the maximum queue length, and trigger an external vibration alarm (EVA) if a minimum percentage of the vibration data is defined as being comprised of respective IAOs.

11. A method of operating an electric arc furnace (EAF) including a furnace body defining an interior portion including a refractory-lined hearth and one or more electrodes extending into the interior portion, the method comprising:
(i) detecting vibration of the one or more electrodes according to claim 10;
(ii) adjusting a location of the one or more electrodes relative to the refractory-lined hearth by raising the one or more electrodes away from the refractory-lined hearth.

12. The method according to claim 11, wherein the computer processor is configured to initiate the step of adjusting the location of the one or more electrodes relative to the refractory-lined hearth.

13. The method according to claim 12, wherein the computer processor is further configured to vary the rate and/or distance of the one or more electrodes based on the number of heats of the one or more electrodes.

14. The method according to claim 13, wherein the computer processor is configured to initiate the step of adjusting the location of the one or more electrodes relative to the refractory-lined hearth at a first rate and/or first distance when the number of heats of the one or more electrodes is below a user defined heat number threshold, and a second rate and/or second distance when the number of heats of the one or more electrodes is above a user defined heat number threshold; and wherein the first rate is greater than the second rate and the first distance is greater than the second distance.

15. An electric arc furnace (EAF) system, comprising:
(i) an electric arc furnace (EAF) including a furnace body defining an interior portion including a refractory-lined hearth and one or more electrodes extending into the interior portion; and
(ii) an electrode vibration detection module (EVDM) according to any of claims 1 to 9.
